# EUROPEAN PATENT APPLICATION

(11) **EP 3 553 602 A1**
(43) Date of publication of application: **16.10.2019**
(21) Application number: 18166389.9
(22) Date of filing: 09.04.2018
(51) Int. Cl.: G03F 7/20

(54) **MODEL BASED RECONSTRUCTION OF SEMICONDUCTOR STRUCTURES**

(71) Applicant: ASML Netherlands B.V., 5500 AH Veldhoven (NL)
(72) Inventor: CHUANG, Chung-Bin, 5500 AH Veldhoven (NL); JACOBS, Sander Silvester Adelgondus Marie, 5500 AH Veldhoven (NL)
(74) Representative: Willekens, Jeroen Pieter Frank

(57) **Abstract**

Methods and apparatus for determining a property of a structure fabricated on a substrate, by determining a measured characteristic from pixels of a measured pupil image of the structure, the measured characteristic comprising less information than the measured pupil image; generating an initial simulated characteristic corresponding to the measured characteristic and based on a candidate model of the structure; comparing the measured characteristic to the simulated characteristic in an iterative method until the difference therebetween is less than a coarse threshold; generating an initial simulated pupil image based on the coarse model as the candidate model; comparing at least a portion of the measured pupil image to at least a portion of the simulated pupil image in an iterative method until the difference therebetween is less than a fine threshold.

## Description

### Technical field

The invention relates to methods and apparatus for reconstruction of a structure fabricated on a substrate based on a model of the structure. More specifically, the invention may relate to reconstruction of the structure using measured electromagnetic radiation diffracted or scattered from the structure and modelled electromagnetic radiation modelled as diffracted or scattered from the model of the structure.

### Background

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such a process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Following fabrication of structures on a substrate in a lithographic process, a metrology process may be followed to determine one or more properties of the structure. In a particular metrology process, the structure may be reconstructed using a library of models of the structure, each model corresponding to the structure but with a slightly different property. In such metrology processes, electromagnetic radiation is diffracted or scattered from the structure and a pupil image is captured in the pupil plane of a detection branch of an optical system of a scatterometer. Also, a simulated pupil image resulting from the same electromagnetic radiation if it were diffracted or scattered from a model of the structure is simulated. Comparison of the measured pupil image and the simulated pupil image results in a difference that is related to the accuracy of the model of the structure when compared to the actual fabricated structure. Through an iterative process, the model can be changed and the same process followed again until the difference is less than a threshold, after which the model is considered to be representative of the structure.

Such methods are lengthy to undertake and are expensive in terms of computation effort.

### Summary

According to the invention in an aspect, there is provided an apparatus for determining a property of a structure, such as a periodic structure, fabricated on a substrate, the apparatus comprising a processor configured to execute computer program code to undertake the method of: determining a measured characteristic from pixels of a measured pupil image of the structure generated from a measurement obtained by an optical apparatus, wherein the measured characteristic comprises less information than the measured pupil image; generating an initial simulated characteristic corresponding to the measured characteristic, the simulated characteristic being based on a candidate model of the structure; comparing the measured characteristic to the simulated characteristic for determining a coarse model of the structure to be a current candidate model of the structure in an iterative method until the difference between the measured characteristic and the simulated characteristic is less than a coarse threshold; generating an initial simulated pupil image based on the coarse model as the candidate model; comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.

Optionally, the measured characteristic comprises an average intensity that is based on an intensity of a plurality of pixels in the measured pupil image, and wherein the simulated characteristic comprises an average intensity corresponding to an intensity of a plurality of pixels in the simulated pupil image.

Optionally, the measured characteristic comprises one or more coefficients for one or more Zernike polynomials for representing the measured pupil image, and wherein the simulated characteristic comprises one or more coefficients for one or more Zernike polynomials for representing the simulated pupil image.

Optionally, the measured characteristic comprises a plurality of measured characteristics relating to a plurality of pupil images obtained using different wavelengths of radiation incident on the structure, and wherein the simulated characteristic comprises a plurality of simulated characteristics relating to different wavelengths of radiation simulated to be incident on the model of the structure.

Optionally, comparing the measured characteristic to the simulated characteristic comprises comparing the plurality of values of the measured characteristic to corresponding values of the simulated characteristic.

Optionally, comparing the measured characteristic to the simulated characteristic comprises comparing a series of the plurality of values of the measured characteristic to a series of the corresponding values of the simulated characteristic, and wherein the coarse threshold comprises a goodness of fit between the series.

Optionally, the simulated characteristic is determined directly based at least in part on the candidate model without first determining the simulated pupil image.

Optionally, the measured characteristic and the simulated characteristic comprise no information relating to an angle at which radiation is scattered or diffracted from the structure or an angle at which radiation is simulated to be scattered or diffracted from the candidate model of the structure respectively.

Optionally, when comparing at least a portion of the measured pupil image to at least a portion of the simulated pupil image, the measured pupil image has been obtained by illuminating the structure with radiation having one wavelength.

According to the invention in an aspect, there is provided an apparatus for determining a property of a structure fabricated on a substrate, the apparatus comprising a processor configured to execute computer program code to undertake the method of: determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images; generating a plurality of initial simulated characteristics corresponding to the measured characteristics, the simulated characteristics being based on a candidate model of the structure simulated to be illuminated by radiation at the plurality of wavelengths; comparing the measured characteristics to the simulated characteristics for determining a coarse model of the structure to be a current candidate model of the structure in an iterative method until the difference between the measured characteristics and the simulated characteristics is less than a coarse threshold.

Optionally, the processor is further configured to execute computer program code to undertake the steps of: generating an initial simulated pupil image based on the coarse model as the candidate model simulated to be illuminated by radiation at one wavelength, and wherein one of the measured pupil images has been obtained by illuminating the structure with radiation at a one wavelengths; comparing at least a portion of the one measured pupil image to at least a portion of the simulated pupil image for determining a fine model of the structure to be a current candidate model of the structure in an iterative method until the difference between the at least a portion of the one measured pupil image and the at least a portion of the simulated pupil image is less than a fine threshold.

According to the invention in an aspect, there is provided a method for determining a property of a structure fabricated on a substrate, the method comprising: determining a measured characteristic from pixels of a measured pupil image of the structure generated from a measurement obtained by an optical apparatus, wherein the measured characteristic comprises less information than the measured pupil image; generating an initial simulated characteristic corresponding to the measured characteristic, the simulated characteristic being based on a candidate model of the structure; comparing the measured characteristic to the simulated characteristic for determining a coarse model of the structure to be a current candidate model of the structure in an iterative method until the difference between the measured characteristic and the simulated characteristic is less than a coarse threshold; generating an initial simulated pupil image based on the coarse model as the candidate model; comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.

According to the invention in an aspect, there is provided a method for determining a property of a structure fabricated on a substrate, the method comprising: determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images; generating a plurality of initial simulated characteristics corresponding to the measured characteristics, the simulated characteristics being based on a candidate model of the structure simulated to be illuminated by radiation at the plurality of wavelengths; comparing the measured characteristics to the simulated characteristics for determining a coarse model of the structure to be a current candidate model of the structure in an iterative method until the difference between the measured characteristics and the simulated characteristics is less than a coarse threshold.

According to the invention in an aspect, there is provided a computer program comprising instructions which, when executed on at least one processor, cause the at least one processor to control an apparatus to carry out a method according to any disclosed herein.

According to the invention in an aspect, there is provided a metrology system for determining one or more properties of a structure fabricated on a substrate and comprising an apparatus for determining a property of a structure fabricated on a substrate according to any disclosed herein.

According to the invention in an aspect, there is provided a lithographic system comprising the metrology system disclosed above.

According to the invention in an aspect, there is provided a lithographic cell system comprising the lithographic system disclosed above.

### Brief description of the drawings

Exemplary embodiments are described herein with reference to the accompanying drawings, in which:
Figure 1 is a depicts a schematic overview of a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4a depicts a schematic representation of a scatterometer;
Figure 4b depicts a schematic representation of a scatterometer;
Figure 5 is a flow diagram of an exemplary iterative process for determining a property of a structure fabricated on a substrate;
Figure 6 is a flow diagram of an exemplary iterative process for determining a property of a structure fabricated on a substrate; and
Figures 7 and 8 show plots of a plurality of measured and simulated characteristics relating to radiation at different wavelengths diffracted or scattered from a structure fabricated on a substrate.

### Detailed description

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

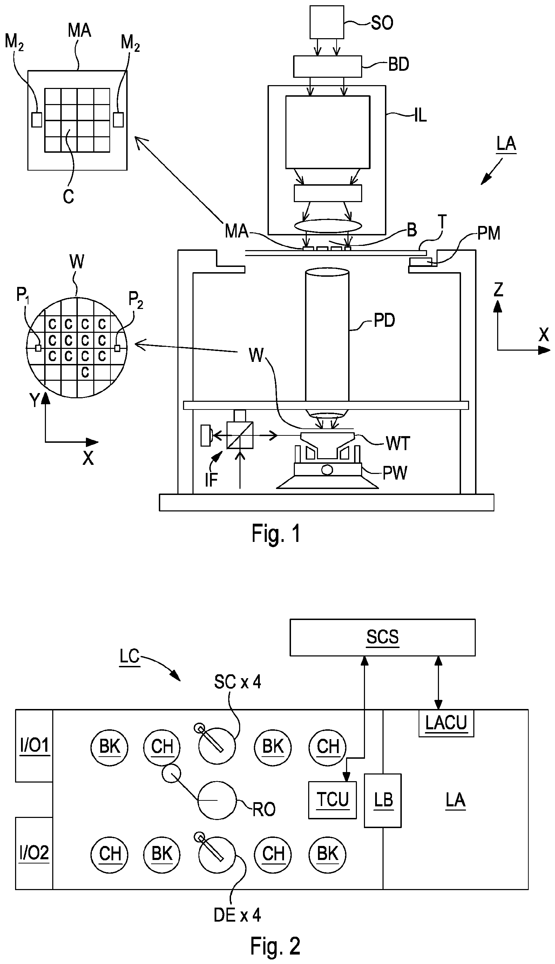

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

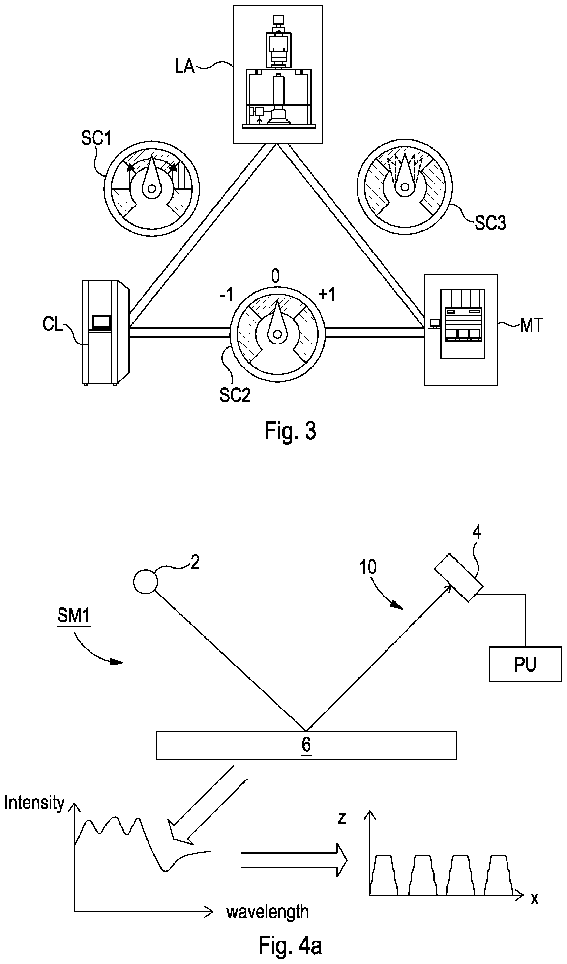

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

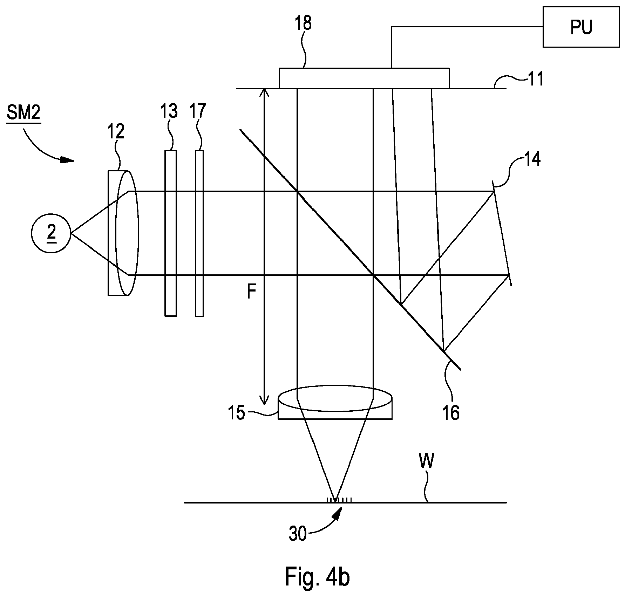

A metrology apparatus, such as a scatterometer, is depicted in figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Another metrology apparatus, such as a scatterometer, that may be used in exemplary arrangements is shown in Figure 4b. In this device, the radiation emitted by radiation source 2 is focused using lens system 12 through interference filter 13 and polarizer 17, reflected by partially reflected surface 16 and is focused onto substrate W via a microscope objective lens 15, which has a high numerical aperture (NA), for example at least 0.8, preferably at least 0.9 and more preferably at least 0.95. Immersion scatterometers may even have lenses with numerical apertures over 1. The reflected radiation then transmits through partially reflective surface 16 into a detector 18 in order to have the scatter spectrum detected. The detector 18 may be located in the back-projected pupil plane 11, which is at the focal length of the lens system 15, however the pupil plane may instead be re-imaged with auxiliary optics (not shown) onto the detector. The pupil plane is the plane in which the radial position of radiation defines the angle of incidence and the angular position defines azimuth angle of the radiation. The detector is preferably a two-dimensional detector so that a two-dimensional angular scatter spectrum of a substrate target 30 can be measured. The detector 18 may be, for example, an array of CCD or CMOS sensors, and may use an integration time of, for example, 40 milliseconds per frame. A pupil image is one captured in the pupil plane.

A reference beam is often used for example to measure the intensity of the incident radiation. To do this, when the radiation beam is incident on the beam splitter 16 part of it is transmitted through the beam splitter as a reference beam towards a reference mirror 14. The reference beam is then projected onto a different part of the same detector 18.

A set of interference filters 13 is available to select a wavelength of interest in the range of, say, 405-790 nm or even lower, such as 200-400 nm, or even higher 800-1000 nm, or a combination of these ranges. The interference filter may be tunable rather than comprising a set of different filters. A grating could be used instead of interference filters.

The detector 18 may measure the intensity of scattered light at a single wavelength (or narrow wavelength range), the intensity separately at multiple wavelengths or integrated over a wavelength range. Furthermore, the detector may separately measure the intensity of transverse magnetic- and transverse electric-polarized light and/or the phase difference between the transverse magnetic- and transverse electric-polarized light.

Using a broadband light source (i.e. one with a wide range of light frequencies or wavelengths—and therefore of colors) is possible, which gives a large etendue, allowing the mixing of multiple wavelengths. The plurality of wavelengths in the broadband preferably each has a bandwidth of Δλ and a spacing of at least 2Δλ (i.e., twice the bandwidth). Several "sources" of radiation can be different portions of an extended radiation source which have been split using fiber bundles. In this way, angle resolved scatter spectra can be measured at multiple wavelengths in parallel. A 3-D spectrum (wavelength and two different angles) can be measured, which contains more information than a 2-D spectrum. This allows more information to be measured which increases metrology process robustness. This is described in more detail in EP1,628,164A, which is incorporated by reference herein in its entirety.

The target 30 on substrate W may be a grating, which is printed such that after development, the bars are formed of solid resist lines. The bars may alternatively be etched into the substrate. This pattern is sensitive to chromatic aberrations in the lithographic projection apparatus, particularly the projection system PL, and illumination symmetry and the presence of such aberrations will manifest themselves in a variation in the printed grating. Accordingly, the scatterometry data of the printed gratings is used to reconstruct the gratings. The parameters of the grating, such as line widths and shapes, may be input to the reconstruction process, performed by processing unit PU, from knowledge of the printing step and/or other scatterometry processes.

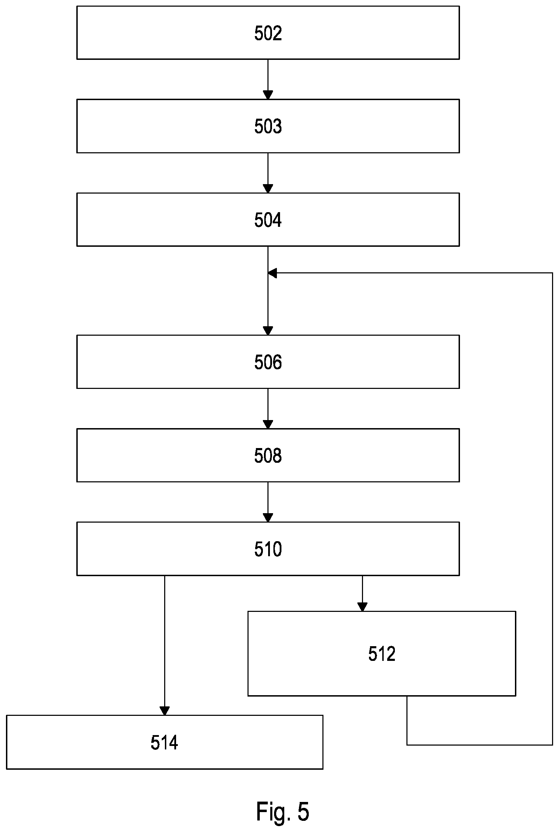

Using one of the scatterometers described herein in combination with modeling of a target structure and its diffraction properties, measurement of the shape and other parameters of the structure can be performed in a number of ways. In an exemplary process, represented by Figure 5, a diffraction pattern based on a first estimate of the target shape (a first model of a structure) is calculated and compared with a measured diffraction pattern from the structure fabricated on the substrate. Parameters of the model are then varied systematically and the diffraction re-calculated in a series of iterations, to generate new candidate structures and so arrive at a best fit. In a further exemplary arrangement, diffraction spectra for many different candidate structures may be calculated in advance to create a 'library' of diffraction spectra. Then the diffraction pattern observed from the measurement target is compared with the library of calculated spectra to find a best fit. Both methods can be used together: a coarse fit can be obtained from a library, followed by an iterative process to find a best fit.

Referring to Figure 5 in more detail, the way the measurement of the target structure shape and/or material properties is carried out will be described in summary. The target will be assumed for this description to be a 1-dimensionally (1-D) structure or a 2-D or 3-D periodic structure. In practice it may be 2-dimensionally periodic, and the processing will be adapted accordingly.

In step 502, a pupil image (or diffraction pattern) of radiation diffracted from the actual target structure on the substrate is measured at a pupil plane of a scatterometer, such as those described above. This measured pupil image is forwarded to a calculation system such as a computer. The calculation system may be the processing unit PU referred to above, or it may be a separate apparatus.

In step 503, a 'model recipe' is established which defines a parameterized model of the target structure in terms of a number of parameters pi (p1, p2, p3 and so on). These parameters may represent for example, in a 1D periodic structure, the angle of a side wall, the height or depth of a feature, the width of the feature. Properties of the target material and underlying layers are also represented by parameters such as refractive index (at a particular wavelength present in the scatterometry radiation beam). Specific examples will be given below. Importantly, while a target structure may be defined by dozens of parameters describing its shape and material properties, the model recipe will define a number of these to have fixed values, while others are to be variable or 'floating' parameters for the purpose of the following process steps.

In step 504: A candidate model target structure shape is estimated, for example, by setting initial values pi<(0) >for the floating parameters (i.e. p1<(0)>, p2<(0)>, p3<(0) >and so on). Each floating parameter will be generated within certain predetermined ranges, as defined in the recipe.

In step 506, the parameters representing the candidate model, together with the optical properties of the different elements of the model, are used to calculate a simulated pupil image (or diffraction pattern) representing the pupil image that would be produced if the actual structure was the same as the candidate modeled structure. This may be done for example using a rigorous optical diffraction method such as RCWA or any other solver of Maxwell equations. This gives an estimated or candidate model diffraction pattern of the model target structure shape.

In steps 508 and 510, the measured pupil image and the simulated pupil image are then compared and their similarities and differences are used to calculate a "merit function" for the model target structure shape.

In step 512, assuming that the merit function indicates that the candidate model needs to be improved before it represents accurately the actual target shape, new parameters p1<(1)>, p2<(1)>, p3<(1)>, etc. are estimated and fed back iteratively into step 506. Steps 506-512 are repeated. In exemplary arrangements, the merit function may be a difference between the measured and simulated pupil images and the difference may be compared to a threshold, such as a threshold value to determine whether further refinement of the model is required. If the difference is below the threshold then the model is considered to be an adequate approximation of the actual target structure.

In order to assist the search, the calculations in step 506 may further generate partial derivatives of the merit function, indicating the sensitivity with which increasing or decreasing a parameter will increase or decrease the merit function, in this particular region in the parameter space. The calculation of merit functions and the use of derivatives is generally known in the art, and will not be described here in detail.

In step 514, when the merit function indicates that this iterative process has converged on a solution with a desired accuracy, the current candidate model is reported as the measurement of the actual target structure.

The computation time of this iterative process is largely determined by the forward diffraction model used, i.e., the calculation of the estimated model diffraction pattern using a rigorous optical diffraction theory from the estimated target structure. If more parameters are required, then there are more degrees of freedom. The calculation time increases in principle with the power of the number of degrees of freedom.

The estimated or model diffraction pattern calculated at 506 can be expressed in various forms. Comparisons are simplified if the calculated pattern is expressed in the same form as the measured pattern generated in step 510. For example, a modeled spectrum can be compared easily with a spectrum measured by the apparatus of Figure 3; a modeled pupil pattern can be compared easily with a pupil pattern measured by the apparatus of Figure 4b.

Throughout this description, the term 'diffraction pattern' is used, on the assumption that the scatterometer of Figure 4 is used. The skilled person can readily adapt the teaching to different types of scatterometer, or even other types of measurement instrument.

In known systems, the method of Figure 5 may be used with a plurality, for example 7 or 21, of different wavelengths of radiation. Further, full pupil images having 100 - 5000 pixels may be measured and simulated although pupil images having fewer than 100 pixels may also be measured and simulated. Optionally, the pupil images have a number of pixels in a range from 500 - 3000. Use of a plurality of wavelengths and full pupil images means that the computational and time burden of the method of Figure 5 is high. Exemplary methods and apparatus disclosed herein comprise a multi-stage approach to determining a property of a structure fabricated on a substrate. The multi-stage approach may comprise coarsely determining the model of the structure and then finely determining the model of the structure.

Broadly, methods and apparatus may coarsely determine the model by determining a measured characteristic of the structure from pixels of a measured pupil image of the structure, generating a simulated characteristic based on a candidate model of the structure and comparing the two in an iterative process similar to that of Figure 5 until a difference between them is less than a threshold. The measured and simulated characteristics comprise less information than the pupil image, which makes the simulated characteristic less expensive in terms of time and computation burden. In some examples the measured and simulated characteristics may be an average intensity of a plurality of pixels of measured and simulated pupil images. However, it is important to note that the solver of Maxwell's equations that is used to determine the simulated pupil image in Figure 5 need not determine the full simulated pupil image before determining the simulated characteristic. Instead, the solver may be configured to determine the simulated characteristic directly based on the candidate model of the structure.

Methods and apparatus disclosed herein may finely determine the model by undertaking the method of Figure 5 using the coarsely determined model as a start point.

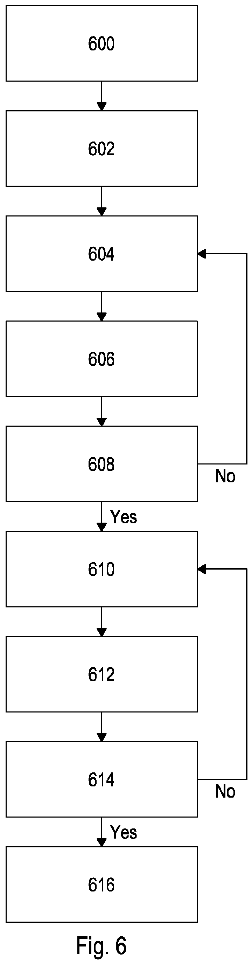

Figure 6 shows a flow diagram of a method for determining a property of a structure fabricated on a substrate. The method may be undertaken by an apparatus for example a metrology apparatus, such as those disclosed herein.

An optical apparatus, such as a scatterometer or other apparatus that may form part of a metrology apparatus may obtain 600 a measured pupil image of the structure to be modeled. As discussed above, the optical apparatus may illuminate the structure with radiation, which is scattered or diffracted from the surface of the structure. At least a portion of the scattered or diffracted radiation is caught by a detection branch of the optical apparatus and is incident on a detector in the pupil plane, which produces the pupil image. In exemplary arrangements, a numerical aperture of the optical apparatus is larger than 0.5, larger than 0.7 or larger than 0.9.

Based on the measured pupil image, a processor of the apparatus determines 602 a measured characteristic. The measured characteristic comprises less information than the measured pupil image. Pupil images contain angular information and intensity information relating to the diffracted or scattered radiation. That is, a location of a pixel of a pupil image relates to the angle and the direction at which the radiation is diffracted or scattered by the structure and the intensity of a pixel is related to the intensity of the diffracted or scattered radiation. In some exemplary arrangements, the measured characteristic may comprise only intensity information. That is, the measured characteristic may comprise no angular information. In some exemplary arrangements, the measured characteristic may comprise an average intensity of a plurality of pixels of the measured pupil image and in a specific arrangement may comprise an average intensity of all pixels in the measured pupil image. For the measured characteristic, this may be determined directly from intensities of the pixels in the measured pupil image.

In yet further arrangements, the measured characteristic may comprise one or more coefficients for one or more Zernike polynomials. The skilled person will appreciate that Zernike polynomials and corresponding coefficients may be used to represent a pupil image.

In some exemplary arrangements, a plurality of pupil images may be obtained using different wavelengths of radiation. There may, for example, be 7 or 21 different wavelengths used and there may therefore be 7 or 21 pupil images. In such arrangements, the measured characteristic may comprise a plurality of measured characteristics that may be determined based on the plurality of pupil images. For example, the average intensity of a plurality of pixels from one of the plurality of pupil images may form each of the measured characteristics.

In a similar way to that in the method of Figure 5, an initial candidate model of the structure is determined 604.

Based on the determined candidate model of the structure, a simulated characteristic is determined 606 which corresponds to the measured characteristic. The simulated characteristic may be determined by the solver based at least in part on the candidate model and Maxwell's equations and corresponds to the characteristic that would be determined from a pupil image obtained from the candidate model of the structure. As already mentioned, the solver may determine the simulated characteristic directly from the candidate model, that is without first determining a simulated pupil image.

In some exemplary arrangements, the simulated characteristic may therefore comprise average intensity data, as discussed above. Further, the simulated characteristic may comprise a plurality of simulated characteristics or simulated values relating to different wavelengths of radiation simulated to be incident on the determined candidate model of the structure. This is discussed in more detail below.

In an iterative process, the measured characteristic is compared 608 to the simulated characteristic to determine a difference between them. If the difference is greater than a coarse threshold then the candidate model of the structure is updated 604 and the simulated characteristic is determined again 606 before repeating the comparison 608. If the difference is below the threshold then the coarse model is determined to be the current candidate model. In exemplary arrangements, the measured and simulated characteristics may be average intensities and in those arrangements, the threshold may be a threshold value of a difference between the average intensities.

On an initial run through the fine determination of the model of the structure, step 610 results in the coarsely determined model being used to begin the fine determination. That is, the coarsely determined model output from the coarse iterative process (604-604) is used as a candidate model to seed the fine iterative process (610-614).

A simulated pupil image is generated 612 based on the coarsely defined model (the candidate model of the structure) in the same way as described above in respect of Figure 5.

At least a part of the simulated pupil image is compared 614 to at least a part of the measured pupil image. In an iterative process, if the difference is greater than a fine threshold, then the candidate model is updated 610, an updated simulated pupil image is generated 612 and the updated simulated pupil image is compared to the measured pupil image. This process is repeated until the difference is below the fine threshold, at which point the current candidate model is output. This process may be undertaken using a pupil image obtained using illumination radiation of one wavelength. The simulated pupil image may be generated based on the same wavelength.

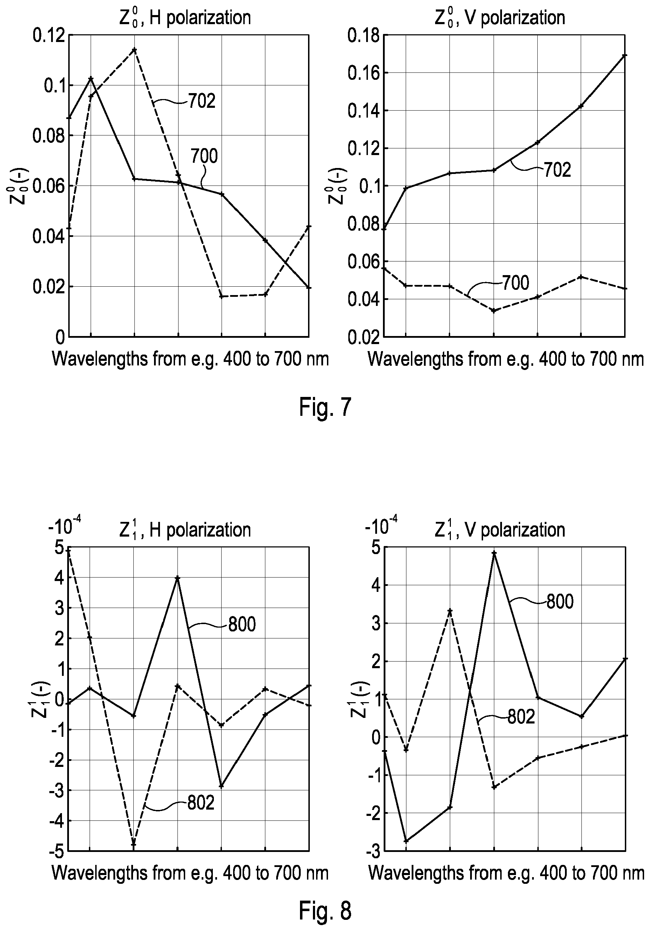

In exemplary arrangements in which multiple measured and simulated characteristics are determined for a plurality of wavelengths, each of the characteristics may be plotted to determine a spectrum for the characteristic across the wavelength range. This may be considered a continuous wavelength behaviour for a characteristic. Comparison of the spectra for the measured characteristic and simulated characteristic (step 608 of Figure 6) can be used to facilitate determination of the coarse model of the structure. This is explained below in conjunction with Figures 7 and 8.

Figures 7 and 8 show series of coefficients of first and second Zernike polynomials respectively. In Figures 7 and 8, the series are plotted to aid description although this need not be done in exemplary implementations of the methods and apparatus disclosed herein. In practice, the first Zernike polynomial actually represents an average intensity of a plurality of pixels of a pupil image. The left hand plots of Figures 7 and 8 show horizontal polarisation and the right hand plots show vertical polarization. The x-axes show wavelength, for example from 400 to 700 nm, and the y-axes show the value of the coefficient.

In the example shown in Figures 7 and 8, seven wavelengths are used and a measured and a simulated coefficient is determined for each wavelength. The measured characteristics in this example are the plots 700, 700', 800, 800' of the first and second Zernike coefficients and the simulated characteristics are plots 702, 702', 802, 802' of the first and second the Zernike coefficients. One, both or more Zernike coefficients may be used in coarse determination of the model.

For the measured characteristics, the Zernike coefficients are determined from the measured pupil images obtained at each wavelength and are plotted 700, 700', 800, 800' as shown in Figures 7 and 8. For the simulated characteristics, the solver determines the Zernike coefficients directly for each wavelength based on the current candidate model and these are plotted 702, 702', 802, 802'as shown in Figures 7 and 8. The fine threshold may in this case be a goodness of fit metric between the plotted spectra. That is, the plots 702, 702', 802, 802'of the simulated characteristics should fit the plots of the measured characteristics 700, 700', 800, 800'within a certain threshold. If the goodness of fit is above the fine threshold then the iterative process (steps 604-608) is repeated, that is the candidate model is determined again 604, the simulated characteristics are determined again 606 and the comparison of the plotted spectra is also repeated 608. If the goodness of fit is below the fine threshold the candidate model is output as the finely determined model of the structure.

The multi wavelength process of plotting measured and simulated spectra discussed above may be used with any measured and simulated characteristic(s).

Further embodiments are disclosed in the subsequent clauses:
1. An apparatus for determining a property of a structure fabricated on a substrate, the apparatus comprising a processor configured to execute computer program code to undertake the method of:
   determining a measured characteristic from pixels of a measured pupil image of the structure generated from a measurement obtained by an optical apparatus, wherein the measured characteristic comprises less information than the measured pupil image;
   generating an initial simulated characteristic corresponding to the measured characteristic, the simulated characteristic being based on a candidate model of the structure;
   comparing the measured characteristic to the simulated characteristic for determining a coarse model of the structure to be a current candidate model of the structure in an iterative method until the difference between the measured characteristic and the simulated characteristic is less than a coarse threshold;
   generating an initial simulated pupil image based on the coarse model as the candidate model; comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.
2. The apparatus according to clause 1, wherein the measured characteristic comprises an average intensity that is based on an intensity of a plurality of pixels in the measured pupil image,
   and wherein the simulated characteristic comprises an average intensity corresponding to an intensity of a plurality of pixels in the simulated pupil image.
3. The apparatus according to clause 1 or 2, wherein the measured characteristic comprises one or more coefficients for one or more Zernike polynomials for representing the measured pupil image, and wherein the simulated characteristic comprises one or more coefficients for one or more Zernike polynomials for representing the simulated pupil image.
4. The apparatus according to any preceding clause, wherein the measured characteristic comprises a plurality of measured characteristics relating to a plurality of pupil images obtained using different wavelengths of radiation incident on the structure,
   and wherein the simulated characteristic comprises a plurality of simulated characteristics relating to different wavelengths of radiation simulated to be incident on the model of the structure.
5. The apparatus according to clause 4, wherein comparing the measured characteristic to the simulated characteristic comprises comparing the plurality of values of the measured characteristic to corresponding values of the simulated characteristic.
6. The apparatus according to clause 5, wherein comparing the measured characteristic to the simulated characteristic comprises comparing a series of the plurality of values of the measured characteristic to a series of the corresponding values of the simulated characteristic,
   and wherein the coarse threshold comprises a goodness of fit between the series.
7. The apparatus of any preceding clause, wherein the simulated characteristic is determined directly based at least in part on the candidate model without first determining the simulated pupil image.
8. The apparatus according to any preceding clause, wherein the measured characteristic and the simulated characteristic comprise no information relating to an angle at which radiation is scattered or diffracted from the structure or an angle at which radiation is simulated to be scattered or diffracted from the candidate model of the structure respectively.
9. The apparatus of any preceding clause, wherein when comparing at least a portion of the measured pupil image to at least a portion of the simulated pupil image, the measured pupil image and/or the simulated pupil image has been obtained by illuminating the structure with radiation having one wavelength.
10. An apparatus for determining a property of a structure fabricated on a substrate, the apparatus comprising a processor configured to execute computer program code to undertake the method of: determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images;
   generating a plurality of initial simulated characteristics corresponding to the measured characteristics, the simulated characteristics being based on a candidate model of the structure simulated to be illuminated by radiation at the plurality of wavelengths;
   comparing the measured characteristics to the simulated characteristics for determining a coarse model of the structure to be a current candidate model of the structure in an iterative method until the difference between the measured characteristics and the simulated characteristics is less than a coarse threshold.
11. The apparatus of clause 10, wherein the processor is further configured to execute computer program code to undertake the steps of:
   generating an initial simulated pupil image based on the coarse model as the candidate model simulated to be illuminated by radiation at one wavelength, and wherein one of the measured pupil images has been obtained by illuminating the structure with radiation at a one wavelengths;
   comparing at least a portion of the one measured pupil image to at least a portion of the simulated pupil image for determining a fine model of the structure to be a current candidate model of the structure in an iterative method until the difference between the at least a portion of the one measured pupil image and the at least a portion of the simulated pupil image is less than a fine threshold.
12. A method for determining a property of a structure fabricated on a substrate, the method comprising:
   determining a measured characteristic from pixels of a measured pupil image of the structure generated from a measurement obtained by an optical apparatus, wherein the measured characteristic comprises less information than the measured pupil image;
   generating an initial simulated characteristic corresponding to the measured characteristic, the simulated characteristic being based on a candidate model of the structure;
   comparing the measured characteristic to the simulated characteristic for determining a coarse model of the structure to be a current candidate model of the structure in an iterative method until the difference between the measured characteristic and the simulated characteristic is less than a coarse threshold;
   generating an initial simulated pupil image based on the coarse model as the candidate model; comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.
13. A method for determining a property of a structure fabricated on a substrate, the method comprising:
   determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images;
   generating a plurality of initial simulated characteristics corresponding to the measured characteristics, the simulated characteristics being based on a candidate model of the structure simulated to be illuminated by radiation at the plurality of wavelengths;
   comparing the measured characteristics to the simulated characteristics for determining a coarse model of the structure to be a current candidate model of the structure in an iterative method until the difference between the measured characteristics and the simulated characteristics is less than a coarse threshold.
14. A computer program comprising instructions which, when executed on at least one processor, cause the at least one processor to control an apparatus to carry out a method according to any one of clauses 12 or 13.
15. A metrology system for determining one or more properties of a structure fabricated on a substrate and comprising the apparatus of any of clauses 1 to 11.
16. A lithographic system comprising the metrology system of clause 15.
17. A lithographic cell system comprising the lithographic system of clause.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

The skilled person will be able to envisage other embodiments without departing from the scope of the appended claims.

## Claims

1. An apparatus for determining a property of a structure fabricated on a substrate, the apparatus comprising a processor configured to execute computer program code to undertake the method of:
determining a measured characteristic from pixels of a measured pupil image of the structure generated from a measurement obtained by an optical apparatus, wherein the measured characteristic comprises less information than the measured pupil image;
generating an initial simulated characteristic corresponding to the measured characteristic, the simulated characteristic being based on a candidate model of the structure;
comparing the measured characteristic to the simulated characteristic for determining a coarse model of the structure to be a current candidate model of the structure in an iterative method until the difference between the measured characteristic and the simulated characteristic is less than a coarse threshold;
generating an initial simulated pupil image based on the coarse model as the candidate model;
comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.

2. The apparatus according to claim 1, wherein the measured characteristic comprises an average intensity that is based on an intensity of a plurality of pixels in the measured pupil image,
and wherein the simulated characteristic comprises an average intensity corresponding to an intensity of a plurality of pixels in the simulated pupil image.

3. The apparatus according to claim 1 or 2, wherein the measured characteristic comprises one or more coefficients for one or more Zernike polynomials for representing the measured pupil image,
and wherein the simulated characteristic comprises one or more coefficients for one or more Zernike polynomials for representing the simulated pupil image.

4. The apparatus according to any preceding claim, wherein the measured characteristic comprises a plurality of measured characteristics relating to a plurality of pupil images obtained using different wavelengths of radiation incident on the structure,
and wherein the simulated characteristic comprises a plurality of simulated characteristics relating to different wavelengths of radiation simulated to be incident on the model of the structure.

5. The apparatus according to claim 4, wherein comparing the measured characteristic to the simulated characteristic comprises comparing the plurality of values of the measured characteristic to corresponding values of the simulated characteristic.

6. The apparatus according to claim 5, wherein comparing the measured characteristic to the simulated characteristic comprises comparing a series of the plurality of values of the measured characteristic to a series of the corresponding values of the simulated characteristic,
and wherein the coarse threshold comprises a goodness of fit between the series.

7. The apparatus of any preceding claim, wherein the simulated characteristic is determined directly based at least in part on the candidate model without first determining the simulated pupil image.

8. The apparatus according to any preceding claim, wherein the measured characteristic and the simulated characteristic comprise no information relating to an angle at which radiation is scattered or diffracted from the structure or an angle at which radiation is simulated to be scattered or diffracted from the candidate model of the structure respectively.

9. The apparatus of any preceding claim, wherein when comparing at least a portion of the measured pupil image to at least a portion of the simulated pupil image, the measured pupil image and/or the simulated pupil image has been obtained by illuminating the structure with radiation having one wavelength.

10. An apparatus for determining a property of a structure fabricated on a substrate, the apparatus comprising a processor configured to execute computer program code to undertake the method of:
determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images;
generating a plurality of initial simulated characteristics corresponding to the measured characteristics, the simulated characteristics being based on a candidate model of the structure simulated to be illuminated by radiation at the plurality of wavelengths;
comparing the measured characteristics to the simulated characteristics for determining a coarse model of the structure to be a current candidate model of the structure in an iterative method until the difference between the measured characteristics and the simulated characteristics is less than a coarse threshold.

11. A method for determining a property of a structure fabricated on a substrate, the method comprising:
determining a measured characteristic from pixels of a measured pupil image of the structure generated from a measurement obtained by an optical apparatus, wherein the measured characteristic comprises less information than the measured pupil image;
generating an initial simulated characteristic corresponding to the measured characteristic, the simulated characteristic being based on a candidate model of the structure;
comparing the measured characteristic to the simulated characteristic for determining a coarse model of the structure to be a current candidate model of the structure in an iterative method until the difference between the measured characteristic and the simulated characteristic is less than a coarse threshold;
generating an initial simulated pupil image based on the coarse model as the candidate model;
comparing at least a portion of the measured pupil image to at least a portion of the simulated pupil image for determining a fine model of the structure to be a current candidate model of the structure in an iterative method until the difference between the at least a portion of the measured pupil image and the at least a portion of the simulated pupil image is less than a fine threshold.

12. A method for determining a property of a structure fabricated on a substrate, the method comprising:
determining a plurality of measured characteristics from pixels of a plurality of measured pupil images of the structure generated from a plurality of measurements obtained by an optical apparatus by illuminating the structure with radiation at a plurality of wavelengths, wherein the measured characteristic comprises less information than the measured pupil images;
generating a plurality of initial simulated characteristics corresponding to the measured characteristics, the simulated characteristics being based on a candidate model of the structure simulated to be illuminated by radiation at the plurality of wavelengths;
comparing the measured characteristics to the simulated characteristics for determining a coarse model of the structure to be a current candidate model of the structure in an iterative method until the difference between the measured characteristics and the simulated characteristics is less than a coarse threshold.

13. A computer program comprising instructions which, when executed on at least one processor, cause the at least one processor to control an apparatus to carry out a method according to any one of claims 11 or 12.

14. A metrology system for determining one or more properties of a structure fabricated on a substrate and comprising the apparatus of any of claims 1 to 10.

15. A lithographic system comprising the metrology system of claim 14.
